# EUROPEAN PATENT SPECIFICATION

(11) **EP 4 075 512 B1**
(45) Date of publication and mention of the grant of the patent: **30.07.2025**
(21) Application number: 21811889.1
(22) Date of filing: 28.05.2021
(51) Int. Cl.: G09G 3/32, H10K 59/121, H10K 59/131, H10K 59/65

(54) **DISPLAY PANEL AND DISPLAY DEVICE**
ANZEIGETAFEL UND ANZEIGEVORRICHTUNG
PANNEAU D'AFFICHAGE ET DISPOSITIF D'AFFICHAGE

(30) Priority: 29.05.2020 CN 202010477260
(43) Date of publication of application: 19.10.2022
(60) Divisional application: 25181876.1
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: LONG, Yue, Beijing 100176 (CN); WANG, Binyan, Beijing 100176 (CN); QIU, Yuanyou, Beijing 100176 (CN); SUN, Kaipeng, Beijing 100176 (CN); LIU, Cong, Beijing 100176 (CN); WU, Chao, Beijing 100176 (CN)
(74) Representative: Haseltine Lake Kempner LLP
(86) International application number: PCT/CN2021/096765
(87) International publication number: WO 2021/239112

(56) References cited:
- CN-A- 110 767 681
- CN-A- 110 890 026
- CN-A- 111 180 483
- CN-A- 111 180 494
- CN-A- 111 326 560
- CN-A- 111 508 377
- CN-A- 111 916 486
- CN-U- 210 245 501
- CN-U- 210 515 985
- CN-U- 210 516 000
- JP-A- 2010 230 797
- US-A1- 2019 393 286
- US-A1- 2020 052 048

## Description

### TECHNICAL FIELD

The present disclosure relates to the field of display technologies, and in particular, to a display panel and a display device.

### BACKGROUND

At present, display screens in display devices are developing towards large screens and full screens so as to provide better visual experience for users. By taking display devices, such as mobile phones and tablet computers, as an example, these display devices need to incorporate components such as cameras and light sensors, and these components are usually mounted on the front (i.e., a side coplanar with the display surface) of the display device, which results in a low screen-to-body ratio of the display device.

US2019393286 A1 describes a display screen which includes a display area including at least two display regions.

### SUMMARY

The present disclosure provides a display panel and a display device. The technical solutions are as follows.

In one aspect, a display panel is provided as defined in claim 1.

In another aspect, a display device is provided as defined in claim 8.

Further advantageous features are defined in the dependent claims.

### BRIEF DESCRIPTION OF THE DRAWINGS

FIG. 1 is a top view of a display panel according to an embodiment of the present disclosure;
FIG. 2 is a schematic diagram of pixel arrangement of the display panel shown in FIG. 1;
FIG. 3 is a top view of another display panel according to an embodiment of the present disclosure;
FIG. 4 is a schematic diagram of pixel arrangement of a further display panel according to an embodiment of the present disclosure;
FIG. 5 is a schematic diagram of pixel arrangement of a still further display panel according to an embodiment of the present disclosure;
FIG. 6 is a schematic diagram of pixel arrangement of a still further display panel according to an embodiment of the present disclosure;
FIG. 7 is a schematic diagram of pixel arrangement of a display panel according to another embodiment of the present disclosure;
FIG. 8 is a schematic diagram of pixel arrangement of another display panel according to another embodiment of the present disclosure;
FIG. 9 is a structural schematic diagram of a display device according to an embodiment of the present disclosure; and
FIG. 10 is a sectional view of the display device shown in FIG. 9 at a position A-A'.

### DETAILED DESCRIPTION

For clearer descriptions of the objects, technical solutions and advantages in the present disclosure, the present disclosure is described in further detail hereinafter with reference to specific embodiments and the accompanying drawings.

It should be noted that unless defined otherwise, technical terms or scientific terms used in one or more embodiments of the present disclosure should have the normal meaning understood by a person of general skill in the art. The terms "first", "second" and similar terms used in one or more embodiments of the present disclosure do not denote any order, quantity, or importance, and are merely used to distinguish different components. The word "comprise" or "include" and similar terms mean that elements or objects appearing before the term cover the listed elements or objects and its equivalents appearing after the term while other elements or objects are not excluded. The term "connection" or "connected" and similar terms are not limited to physical or mechanical connection, and may include electrical connection and the connection may be direct or indirect. The terms "upper", "lower", "left", "right" and the like are used to denote a relative position relationship. If an absolute position of the described object changes, the relative position relationship may also change accordingly.

At present, to increase the screen-to-body ratio of a display device, a display panel in the display device may be designed as a partially light-transmitting display panel. For example, the display panel includes a normal display portion and a light-transmitting display portion. Each of the normal display portion and the light-transmitting display portion is provided with pixels, so that both the normal display portion and the light-transmitting display portion may display pictures.

A photosensitive sensor (such as an image sensor, an infrared sensor or a distance sensor in a camera) in the display device is on a side, opposite to a display surface, of the display panel, and an orthographic projection of a photosensitive surface of the photosensitive sensor on the display panel is in the light-transmitting display portion. The pixels per inch (PPI) of the normal display portion is higher than the PPI of the light-transmitting display portion, so that ambient light may enter a light-receiving surface of the photosensitive sensor through the light-transmitting display portion. Thus, it can be ensured that the photosensitive sensor can work normally in cases where the screen-to-body ratio of the display device is relatively high.

However, at present, a signal line (such as a data line) and a pixel driving circuit usually need to be arranged in the light-transmitting display portion of the display panel. The signal line and the pixel driving circuit usually do not transmit light, resulting in relatively low light transmittance of the light-transmitting display portion to the ambient light, and thus a relatively poor performance of the photosensitive sensor. For example, when the photosensitive sensor is the image sensor in the camera, the light-transmitting display portion with the relatively low light transmittance will lead to relatively poor quality of an image captured by the camera.

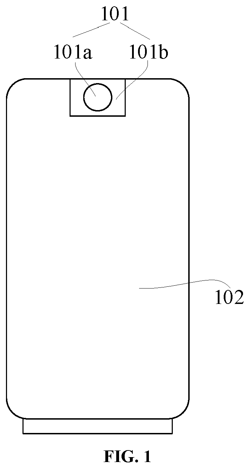

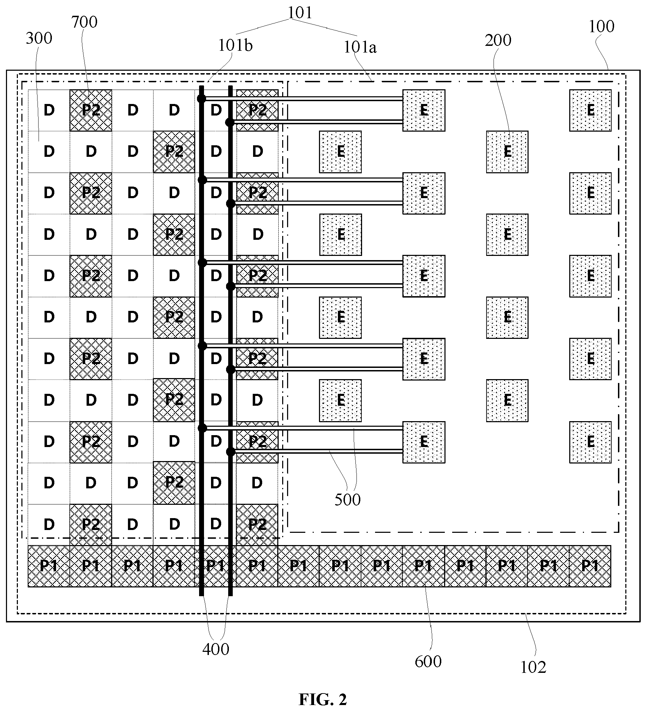

FIG. 1 is a top view of a display panel according to an embodiment of the present disclosure; and FIG. 2 is a schematic diagram of pixel arrangement of the display panel shown in FIG. 1. The display panel may include:
a substrate 100, and a plurality of first light-emitting devices 200 (a block E as shown in FIG. 2 represents one first light-emitting device), a plurality of first pixel driving circuits 300 (a block D as shown in FIG. 2 represents one first pixel driving circuit) and a plurality of first signal lines 400, which are on the substrate 100.

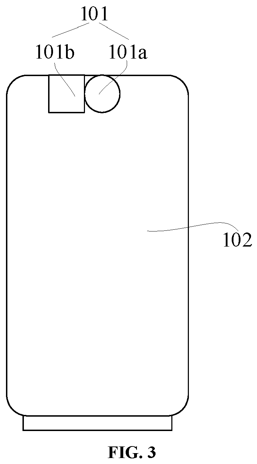

The substrate 100 includes a first display region 101. The first display region 101 includes a light-transmitting region 101a and a non-light-transmitting region 101b. It should be noted that a schematic description is given in FIG. 1 by taking that the non-light-transmitting region 101b is an annular region and is around the light-transmitting region 101a as an example. In other optional embodiments, as shown in FIG. 3, which is a top view of another display panel according to an embodiment of the present disclosure, the non-light-transmitting region 101b may be on one side of the light-transmitting region 101a.

In the embodiment of the present disclosure, the plurality of first light-emitting devices 200 may be arranged in an array and all in the light-transmitting region 101a. The first pixel driving circuits 300 may also be arranged in an array and all in the non-light-transmitting region 101b.

It should be noted that the number of first pixel driving circuits 300 in the non-light-transmitting region 101b is greater than or equal to the number of first light-emitting devices 200 in the light-transmitting region 101a. Each first light-emitting device 200 may be electrically connected with one first pixel driving circuit 300. In this way, each first pixel driving circuit 300 may drive one first light-emitting device 200 to emit light.

The plurality of first signal lines 400 all may be outside the light-transmitting region 101a, and the first signal line 400 may be electrically connected with the first pixel driving circuit 300. In an exemplary embodiment, one first signal line 400 may be electrically connected with each first pixel driving circuit in a column of first pixel driving circuits 300.

It should be noted that the first signal line 400 in the embodiment of the present disclosure may be a data line, and the description is given by taking that various signal lines (such as second signal lines, third signal lines and fourth signal lines) shown in the following embodiments all are data lines as an example. The first signal line 400 may provide a driving signal for the first light-emitting device 200 through the first pixel driving circuit 300, so that the first light-emitting device 200 emits light.

In the embodiment of the present disclosure, the first light-emitting device 200 may be an organic light-emitting diode (OLED) light-emitting device, and may include an anode, a light-emitting layer and a cathode, which are stacked in a direction perpendicular to and distal from the substrate 10. The anode in the first light-emitting device 200 may be electrically connected with the first pixel driving circuit. Both the anode and the cathode may be made of a light-transmitting conductive material. For example, the light-transmitting conductive material may be indium tin oxide (ITO). In this way, the light transmittance of the first light-emitting device 200 in the light-transmitting region 101a is relatively high, so that the light transmittance of the light-transmitting region 101a is high.

As shown in FIG. 2, the display panel may further include a plurality of connecting lines 500 on the substrate 100. One end of each connecting line 500 is electrically connected with one first light-emitting device 200 in the light-transmitting region 101a, and the other end thereof is electrically connected with one first pixel driving circuit 300 in the non-light-transmitting region 101b. In this way, each first light-emitting device 200 may be electrically connected with one first pixel driving circuit 300 through one connecting line.

In an exemplary embodiment, a portion, in the light-transmitting region 101a, of each connecting line 500 may be made of a transparent conductive material. In this way, the light transmittance of the light-transmitting region 101a may be increased further. For simplifying a manufacturing process of the connecting lines 500, the connecting lines 500 all may be made of the transparent conductive material. The transparent conductive material may be ITO.

It should be noted that FIG. 2 only shows an electrical connecting fashion of a column of first light-emitting devices 200 among the plurality of first light-emitting devices 200 and a column of first pixel driving circuits 300 among the first pixel driving circuits 300. Connecting fashions of other first light-emitting devices and other first pixel driving circuits all are the same as this connecting fashion.

In summary, the display panel according to the embodiment of the present disclosure includes the substrate, and the plurality of first light-emitting devices, the first pixel driving circuits and the plurality of first signal lines, which are on the substrate. As only the first light-emitting devices are in the light-transmitting region of the substrate, the first pixel driving circuits electrically connected with the first light-emitting devices are in the non-light-transmitting region, and the first signal lines electrically connected with the first pixel driving circuits are outside the light-transmitting region. The light transmittance of the light-transmitting region of the substrate is relatively high. When the display panel is integrated in a display device, it can be ensured that a photosensitive sensor in the display device has a better performance in the case where the screen-to-body ratio of the display device is relatively high. For example, when the photosensitive sensor is an image sensor in a camera, as the light transmittance of the light-transmitting region is relatively high, the camera may capture images having relatively high quality after ambient light enters the camera through the light-transmitting region.

In the embodiment of the present disclosure, as shown in FIG. 2, each first light-emitting device 200 and the first pixel driving circuit 300 connected thereto may constitute a first pixel unit. The substrate 100 further includes a second display region 102 on a periphery of the first display region 101. The display panel further includes a plurality of second pixel units 600 (a block P1 as shown in FIG. 2 represents one second pixel unit) arranged in an array in the second display region 102, and a plurality of third pixel units 700 (a block P2 as shown in FIG. 2 represents one third pixel unit) arranged in an array in the non-light-transmitting region 101b.

Each second pixel unit 600 may include a second light-emitting device, and a second pixel driving circuit electrically connected with the second light-emitting devices. The second pixel driving circuit is configured to drive the second light-emitting device to emit light. Each third pixel unit 700 may include a third light-emitting device, and a third pixel driving circuit electrically connected with the third light-emitting device. The third pixel driving circuit is configured to drive the third light-emitting device to emit light. In the embodiment of the present disclosure, the second light-emitting device and the third light-emitting device may both be OLED light-emitting devices.

In the present disclosure, the plurality of third pixel driving circuits and the first pixel driving circuits 300 may be alternately in the non-light-transmitting region 101b in the first display region 101. That is, one first pixel driving circuit 300 is between two adjacent third pixel units 700, and one third pixel unit 700 is between two adjacent first pixel driving circuits 300.

In the first display region 101, the arrangement density of the third light-emitting devices may be equal to the arrangement density of the first light-emitting devices 200. Besides, the arrangement density of the third light-emitting devices may not be equal to the arrangement density of the first light-emitting devices 200. The arrangement density of the second light-emitting devices in the second display region 102 is higher than the arrangement density of the third light-emitting devices in the first display region 101. That is, the PPI of the second display region 102 is higher than the PPI of the first display region 101, which ensures a good display effect of the second display region 102.

It should be noted that, in FIG. 2, each first light-emitting device 200 includes two light-emitting sub-devices. Correspondingly, each first pixel driving circuit 300 includes two corresponding sub-pixel driving circuits, and each first signal line 400 includes two corresponding connecting sub-wires. In this way, a column of sub-pixel driving circuits may be electrically connected with one corresponding connecting sub-wire, and each light-emitting sub-device in the first light-emitting device 200 may be electrically connected with the corresponding sub-pixel driving circuit through one connecting line 500. The two light-emitting sub-devices in each first light-emitting device 200 may be light-emitting sub-devices of two different colors, respectively. For example, the light-emitting sub-devices of two different colors are a red light-emitting sub-device and a green light-emitting sub-device, respectively; a red light-emitting sub-device and a blue light-emitting sub-device, respectively; or a green light-emitting sub-device and a blue light-emitting sub-device, respectively.

For ease of viewing, the following embodiments are schematically described y taking that each first light-emitting device 200 is one light-emitting sub-device, each first pixel driving circuit 300 is one sub-pixel driving circuit, and each first light-emitting device 200 is electrically connected with one first pixel driving circuit 300 through one connecting line 500 as an example.

In the embodiment of the present disclosure, there are various wiring directions of the first signal line 400. The embodiment of the present disclosure is schematically described by taking the following two optional implementation modes as an example.

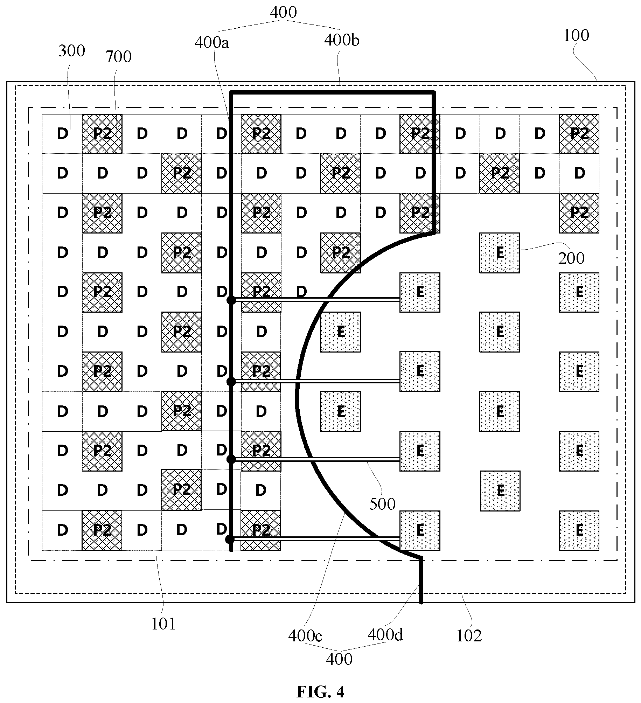

In a first optional implementation mode, as shown in FIG. 4, which is a schematic diagram of pixel arrangement of a further display panel according to an embodiment of the present disclosure, the first signal line 400 may include a first connecting portion 400a, a jumper portion 400b, a winding portion 400c, and a second connecting portion 400d, which are sequentially connected. The first connecting portion 400a is in the non-light-transmitting region 101b and electrically connected with each first pixel driving circuit in a column of first pixel driving circuits 300. The second connecting portion 400d is in the second display region 102 and electrically connected with the second pixel driving circuits in a column of second pixel units 600. One end of the winding portion 400c is connected with the second connecting portion 400d, and the winding portion 400c is outside the light-transmitting region 101b and extends along an outer boundary of the light-transmitting region 101b. One end of the jumper portion 400b is connected with the winding portion 400c, and the other end thereof is connected with the first connecting portion 400a. In this way, a driving signal loaded on the first signal line 400 may not only drive the first light-emitting device 200 to emit light through the first pixel driving circuit 300, but also drive the second light-emitting device to emit light through the second pixel driving circuit in the second pixel unit 600.

It should be noted that one end, distal from the jumper portion 400b, of the first connecting portion 400a needs to be disconnected from a signal line in the second display region 102.

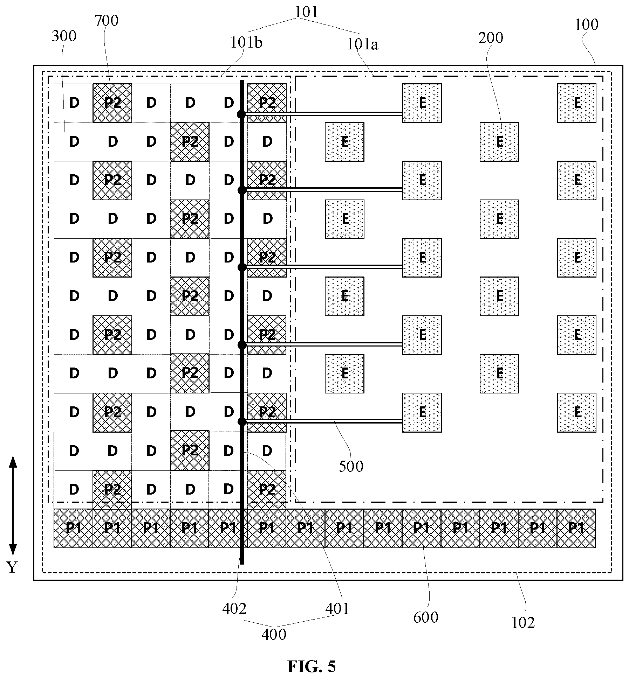

In a second optional implementation mode, as shown in FIG. 5, which is a schematic diagram of pixel arrangement of a still further display panel according to an embodiment of the present disclosure, the first pixel driving circuits 300 are arranged in a plurality of columns and column directions of the first pixel driving circuits 300 all are a direction Y. An extending direction of the first signal lines 400 is parallel to a column direction of the plurality of first pixel units 200. That is, the extending direction of the first signal lines 400 is parallel to the direction Y. It should be noted that the schematic description is given in the drawings of the present disclosure by taking that the first display region 101 is a regular rectangular region as an example. When the shape of the first display region 101 is an irregular shape (such as a circle or a triangle), the first pixel driving circuits 300 arranged in the first display region 101 are also arranged irregularly, but may still be arranged in a plurality of columns in a direction perpendicular to the direction Y, and each column of first pixel driving circuits 300 may be connected with one first signal line 400.

In this case, the first signal line 400 may include a first connecting portion 401 and a second connecting portion 402 which are connected. The first connecting portion 401 may be in the non-light-transmitting region 101b and electrically connected with each first pixel driving circuit in a column of first pixel driving circuits 300. The second connecting portion 402 may be in the second display region 102 and electrically connected with the second pixel driving circuits in a column of second pixel units 600. In this way, a driving signal loaded on the first signal line 400 may not only drive the first light-emitting device 200 to emit light through the first pixel driving circuit 300, but also drive the second light-emitting device to emit light through the second pixel driving circuit in the second pixel unit 600.

It should be noted that signal lines, other than the first signal lines 400, in the second display region 102 do not extend into the first display region 101.

In the above two optional implementation modes, for the first optional implementation mode, the number of the first signal lines 400 is large, and the winding portion 400c in the first signal line400 occupies part of space. Therefore, the arrangement density of the third pixel units 700 in the non-light-transmitting region 101b is affected by arranging the first signal lines 400 provided with the winding portions 400c, which limits the aperture ratio of the display panel.

For the second optional implementation mode, the first signal line 400 is provided with no winding portion, the extending direction of the first signal lines 400 is parallel to the column direction (i.e., the direction Y) of the first pixel driving circuits 300, and each first signal line 400 is in a region where a column of first pixel driving circuits 300 is, which does not affect the arrangement density of the third pixel units 700 in the non-light-transmitting region 101b. Thus, the aperture ratio of the display panel is relatively high.

For this reason, the second optional implementation mode has a better effect than the first optional implementation mode, and the following embodiments are all schematically described by taking the first signal line 400 and the direction Y as an example. It should be noted that the above two optional implementation modes are both described by taking that the first signal line 400 drives both the first light-emitting device 200 and the second light-emitting device to emit light as an example. The following embodiments are described by taking that the first light-emitting device and the second light-emitting device are driven by different signal lines as an example.

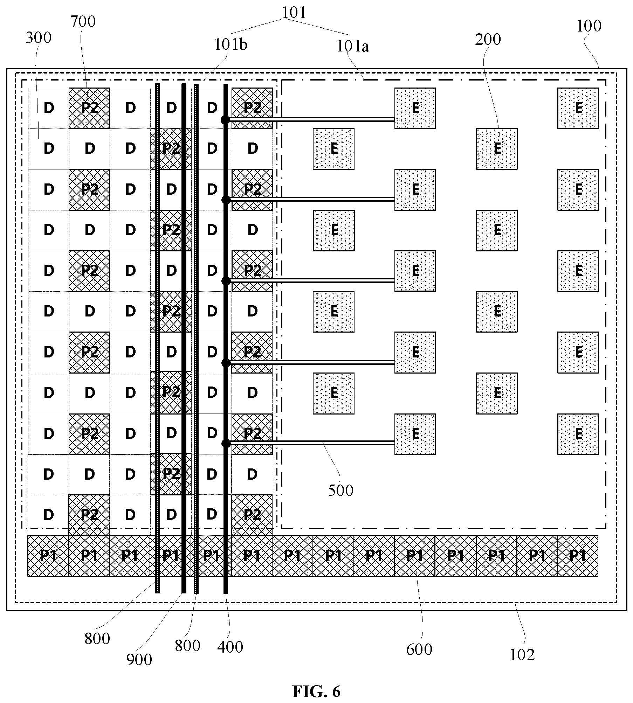

As shown in FIG. 6, which is a schematic diagram of pixel arrangement of a still further display panel according to an embodiment of the present disclosure, the display panel may further include a plurality of signal lines 800 on the substrate 100. The second signal line 800 is electrically connected with the second pixel driving circuit in the second pixel unit 600 and disconnected from the first pixel driving circuits 300. The first signal line 400 is electrically connected with the first pixel driving circuit 300 and disconnected from the second pixel driving circuits.

In the embodiment of the present disclosure, the plurality of first signal lines 400 are configured to be connected with a first driving chip; and the plurality of second signal lines 800 are configured to be connected with a second driving chip. In this way, under the control of the first driving chip, the first signal line 400 may drive the first light-emitting device to emit light through the first pixel driving circuit 300; and under the control of the second driving chip, the second signal line 800 may drive the second light-emitting device to emit light through the second pixel driving circuit.

Optionally, the display panel may further include a plurality of fifth signal lines 900 on the substrate 100. The fifth signal line 900 may be electrically connected with the third pixel driving circuit in the third pixel unit 700 and disconnected from the second pixel driving circuits. The plurality of fifth signal lines 900 are configured to be connected with the first driving chip. In this way, under the control of the first driving chip, the fifth signal line may drive the third light-emitting device to emit light through a third pixel unit.

In this way, only the pixel units in the first display region 101 may be controlled by the first driving chip, and only the pixel units in the second display region 102 may be controlled by the second driving chip. That is, the first display region 101 with the lower PPI and the second display region 102 with the higher PPI need to be controlled by different driving chips. Thus, it can be ensured that the luminous brightness of a picture displayed in the first display region 101 with the lower PPI is higher, and the uniformity of the display panel is better.

In the embodiment of the present disclosure, the substrate 100 further includes a bonding region (not marked in FIG. 6) outside the second display region 102, and the bonding region is configured for mounting the first driving chip and the second driving chip. When the bonding region is at different sides of the second display region 102, the arrangement fashions of the signal lines in the display panel are also different. The embodiments of the present disclosure are described by taking the following two exemplary implementation modes as an example.

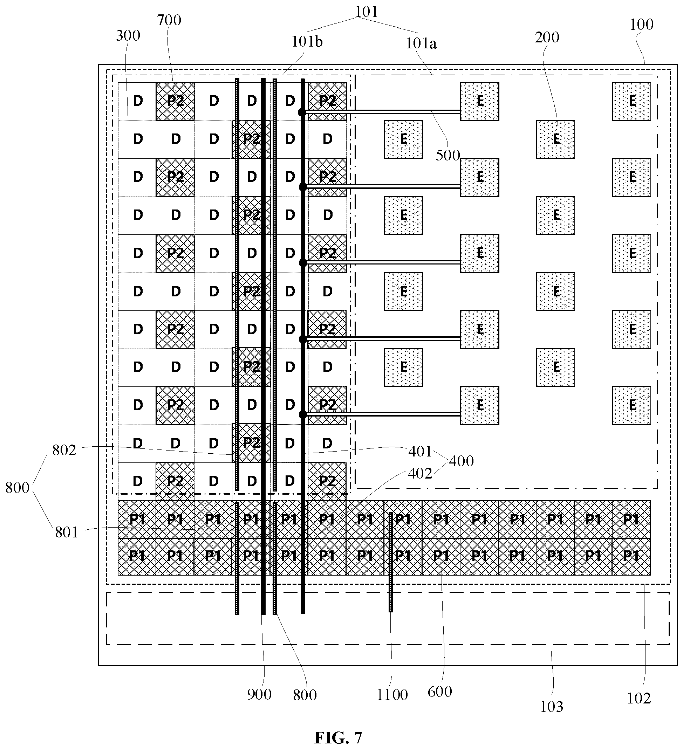

In a first exemplary implementation mode, FIG. 7 is a schematic diagram of pixel arrangement of a display panel according to another embodiment of the present disclosure. The bonding region 103 in the substrate 100 is distal from a side, on which the first display region 101 is, of the second display region 102. In this case, the first signal line 400 includes a first connecting portion 401 and a second connecting portion 402, which are connected. The first connecting portion 401 may be in the non-light-transmitting region 101b and electrically connected with each first pixel driving circuit in a column of first pixel driving circuits 300; and the second connecting portion 402 may be in the second display region 102 and disconnected from the second pixel driving circuits in the second pixel unit 600.

In an exemplary embodiment, the first pixel driving circuit 300 and the second pixel driving circuit are on the same layer, and an insulating layer exists between each of the first pixel driving circuit 300 and the second pixel driving circuit and the first signal line 400. The insulating layer between the first connecting portion 401 in the first signal line 400 and the first pixel driving circuit 300 is provided with a via hole, and the first connecting portion 401 may be electrically connected with the first pixel driving circuit through the via hole. The insulating layer between the second connecting portion 402 in the first signal line 400 and the second pixel driving circuit is provided with no via hole, and the second connecting portion 402 may be disconnected from the second pixel driving circuits through the insulating layer. In this way, a driving signal provided by the first driving chip may be transmitted to the first connecting portion 401 through the second connecting portion 402, so that the first connecting portion 401 is capable of driving the first light-emitting device 200 to emit light through the first pixel driving circuit 300.

It should be noted that the structure of the fifth signal line 900 may be the same as the structure of a first signal line 300, and is not repeated here.

In the present disclosure, a variety of cases exist for the structure of the second signal line 800 and the embodiment of the present disclosure is schematically described by taking the following two cases as an example.

In a first case, all of the second signal lines 800 are in the second display region 102. That is, the second signal line 800 does not extend into the first display region 101.

In a second case, the second signal line 800 includes a third connecting portion 801 and a fourth connecting portion 802. The third connecting portion 801 is in the second display region 102 and electrically connected with the second pixel driving circuits in a column of second pixel units 600; and the fourth connecting portion 802 is in the non-light-transmitting region 101b and disconnected from the first pixel driving circuit. It should be noted that the specific structure and principle involved in the situation that the second signal line 800 is electrically connected with the second pixel driving circuit and disconnected from the first pixel driving circuits 300 may refer to the relevant description in the first signal line 400, and are not repeated in the embodiment of the present disclosure here.

In the embodiment of the present disclosure, the third connecting portion 801 and the fourth connecting portion 802 in the second signal line 800 may be electrically connected with or disconnected from each other. In an exemplary embodiment, as shown in FIG. 7, when the third connecting portion 801 is disconnected from the fourth connecting portion 802, the third connecting portion 801 and the fourth connecting portion 802 may be disconnected at an intersection of the second display region 102 and the non-light-transmitting region 101b. In this way, a driving signal applied by the second driving chip to the second signal line 800 is not loaded on the fourth connecting portion 802, thereby avoiding the problem of interfering with the non-light-transmitting region 101b and thus improving the display effect of the first display region 101.

Optionally, the display panel may further include a plurality of third signal lines 1000 on the substrate 100. The third signal lines 1000 all are in the second display region 102, and the third signal line 1000 is electrically connected with the second pixel driving circuits in a column of second pixel units. The plurality of third signal lines 1000 are configured to be connected to the second driving chip. In this way, under the control of the second driving chip, the third signal line 1000 may drive the second light-emitting device to emit light through the second pixel driving circuit.

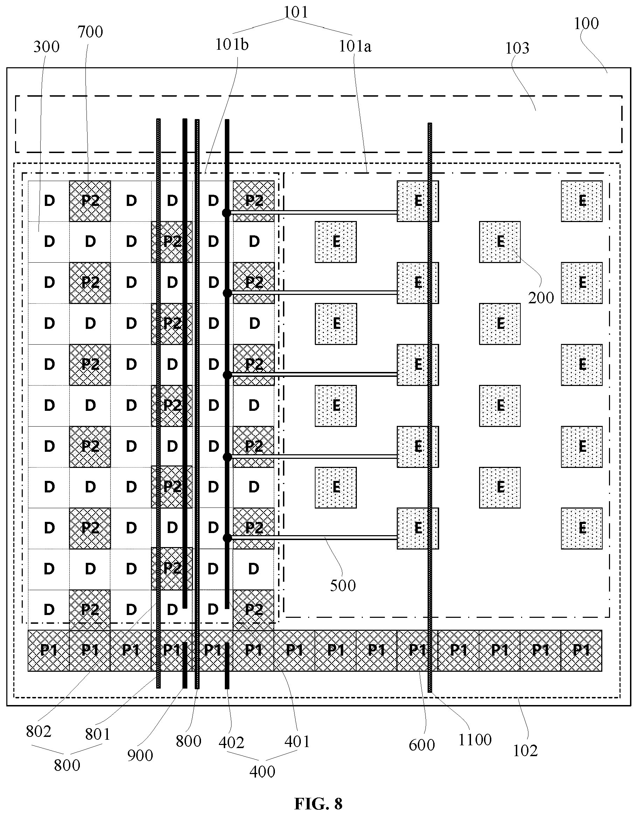

In a second exemplary implementation mode, FIG. 8 is a schematic diagram of pixel arrangement of another display panel according to another embodiment of the present disclosure. The bonding region 103 in the substrate 100 is proximal to a side, on which the first display region 101 is, of the second display region 102. In this case, the second signal line 800 includes a third connecting portion 801 and a fourth connecting portion 802, which are connected. The third connecting portion 801 is in the second display region 102 and electrically connected with the second pixel driving circuits in a column of second pixel units 600; and the fourth connecting portion 802 is in the non-light-transmitting region 101b and disconnected from the first pixel driving circuits 300.

In an exemplary embodiment, the first pixel driving circuit 300 and the second pixel driving circuit are on the same layer, and an insulating layer exists between each of the first pixel driving circuit 300 and the second pixel driving circuit and the second signal line 800. The insulating layer between the third connecting portion 801 in the second signal line 800 and the second pixel driving circuit is provided with a via hole, and the third connecting portion 801 may be electrically connected with the second pixel driving circuit through the via hole. The insulating layer between the fourth connecting portion 802 in the second signal line 800 and the first pixel driving circuit is provided with no via hole, and the fourth connecting portion 802 may be disconnected from the first pixel driving circuits through the insulating layer. In this way, a driving signal provided by the second driving chip may be transmitted to the third connecting portion 801 through the fourth connecting portion 802, so that the third connecting portion 801 is capable of driving the second light-emitting device to emit light through the second pixel driving circuit 300.

Optionally, the display panel may further include a plurality of third signal lines (not drawn in FIG. 8) and a plurality of fourth signal liens 1100, which are on the substrate 100. The third signal lines 1000 all are in the second display region 102, and each of the third signal lines is electrically connected with the second pixel driving circuits in a column of second pixel units 600. A part of each of the fourth signal lines 1100 is in the second display region 102, and the other part of fourth signal lines 1100 is in the light-transmitting region 101a. The fourth signal line 1100 is electrically connected with the second pixel driving circuits in a column of second pixel units 600. The plurality of third signal lines and the plurality of fourth signal lines 1100 are configured to be connected with the second driving chip. In this way, under the control of the second driving chip, the third signal line and the fourth signal line 1100 may drive the second light-emitting device to emit light through the second pixel driving circuit.

In this case, the fourth signal line 1100 needs to extend into the second display region 102 after crossing the light-transmitting region 101a. Therefore, to increase the light transmittance of the light-transmitting region 101a, a portion, in the light-transmitting region 101a, of the fourth signal line 100 may be made of a transparent conductive material.

In the present disclosure, a variety of cases exist for the structure of the first signal line 400 and the embodiment of the present disclosure is schematically described by taking the following two cases as an example.

In a first case, all of the first signal lines400 are in the non-light-transmitting region 101b. That is, the first signal line 400 does not extend into the second display region 102.

In a second case, the first signal line 400 includes a first connecting portion 401 and a second connecting portion 402. The first connecting portion 401 may be in the non-light-transmitting region 101b and electrically connected with each first pixel driving circuit in a column of first pixel driving circuits 300; and the second connecting portion 402 may be in the second display region 102 and disconnected from the second pixel driving circuits in the second pixel unit 600. It should be noted that the specific structure and principle involved in the situation that the first signal line 400 is electrically connected with the first pixel driving circuit 300 and disconnected from the second pixel driving circuits may refer to the relevant description in the second signal line 800, and are not repeated in the embodiment of the present disclosure here.

In the embodiment of the present disclosure, the first connecting portion 401 and the second connecting portion 402 in the first signal line 400 may be electrically connected with or disconnected from each other. In an exemplary embodiment, as shown in FIG. 8, when the first connecting portion 401 is disconnected from the second connecting portion 402, the first connecting portion 401 and the second connecting portion 402 may be disconnected at an intersection of the second display region 102 and the non-light-transmitting region 101b. In this way, a driving signal applied by the first driving chip to the first signal line 400 is not loaded on the second connecting portion 402, thereby avoiding the problem of interfering with the second display region 102 and thus improving the display effect of the second display region 102.

It should be noted that the structure of the fifth signal line 900 may be the same as the structure of the first signal line 400, and is not repeated here.

A person skilled in the art may clearly understand that for ease of viewing, in the accompanying drawings in the present disclosure, only a connecting fashion of one signal line and a column of pixel units is drawn. As for connecting relationships of other pixel units and the signal lines, reference may be made to this connecting fashion drawn in the accompanying drawings.

In summary, the display panel according to the embodiment of the present disclosure includes the substrate, and the plurality of first light-emitting devices, the first pixel driving circuits and the plurality of first signal lines, which are on the substrate. As only the first light-emitting devices are in the light-transmitting region of the substrate, the first pixel driving circuits electrically connected with the first light-emitting devices are in the non-light-transmitting region, and the first signal lines electrically connected with the first pixel driving circuits are outside the light-transmitting region. The light transmittance of the light-transmitting region of the substrate is relatively high. When the display panel is integrated in a display device, it can be ensured that a photosensitive sensor in the display device has a better performance in the case where the screen-to-body ratio of the display device is relatively high. For example, when the photosensitive sensor is an image sensor in a camera, as the light transmittance of the light-transmitting region is relatively high, the camera may capture images having relatively high quality after ambient light enters the camera through the light-transmitting region.

An embodiment of the present disclosure further provides a display device. The display device may be any product or component having a display function, such as a mobile phone, a tablet computer, a television, a display, a laptop computer, a digital photo frame and a navigator.

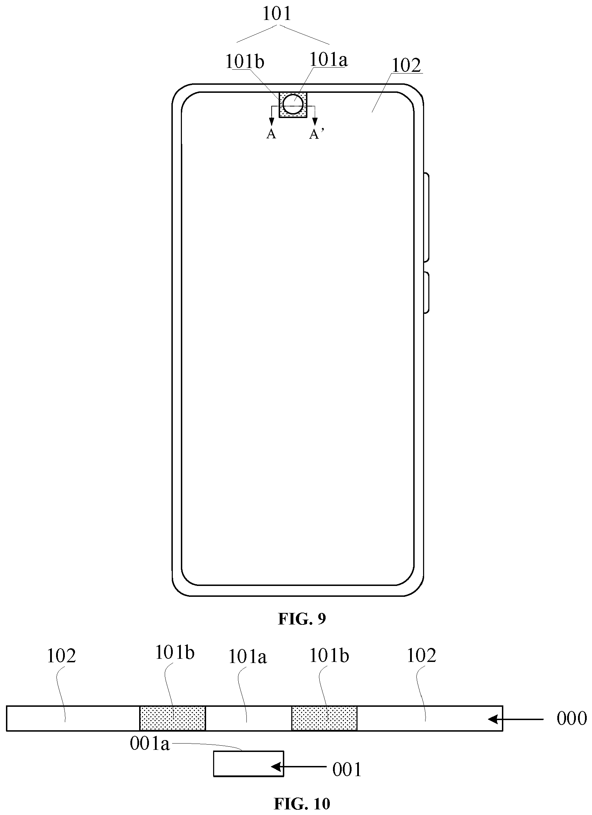

As shown in FIG. 9 and FIG. 10, FIG. 9 is a structural schematic diagram of a display device according to an embodiment of the present disclosure, and FIG. 10 is a sectional view of the display device shown in FIG. 9 at a position A-A'. The display device may include a display panel 000. The display panel 000 may be the display panel in the above embodiment structurally. For example, the display panel may be the display panel shown in FIG. 1, FIG. 4, FIG. 5, FIG. 6, FIG. 7 or FIG. 8.

The display device may include a first display region 101 and a second display region 102. The first display region 101 includes a light-transmitting region 101a and a non-light-transmitting region 101b. The light-transmitting region 101a may take the shape of a circle, an ellipse or two ellipses in parallel, which is not limited in the embodiment of the present disclosure.

In the embodiment of the present disclosure, the display device may further include a photosensitive sensor 001. The photosensitive sensor 001 may be an image sensor, a light sensor, a distance sensor or the like in a camera. The photosensitive sensor 001 is on a side opposite to a display surface of the display panel 000. An orthographic projection of a photosensitive surface 001a of the photosensitive sensor 001 on the display panel is in the light-transmitting region 101a in the first display region 101.

It should be noted that in the accompanying drawings, the dimensions of layers and regions may be exaggerated for the clarity of illustration. In addition, it may be understood that when an element or a layer is referred to as "on" another element or layer, the element or layer may be directly on the other element, or there may be an intermediate layer. Furthermore, it may be understood that when an element or a layer is referred to as "under" another element or layer, the element or layer may be directly under the other element, or there may be more than one intermediate layer or element. Moreover, it may also be understood that when a layer or an element is referred to as being "between" two layers or two elements, the layer or element may be the only one layer between the two layers or the two elements, or there may be more than one intermediate layer or element. Similar reference numerals indicate similar elements throughout the text.

Described above are preferred embodiments of the present disclosure, and are not intended to limit the present disclosure. Any modifications, improvements and the like made within the scope of the appended claims should be included within the scope of protection.

## Claims

1. A display panel, comprising:
a substrate (100) comprising a first display region (101), wherein the first display region (101) comprises a first display sub-region (101a) and a second display sub-region (101b);
a plurality of first light-emitting devices (200) arranged in an array in the first display sub-region (101a), wherein columns of first light-emitting devices (200) are arranged in a first direction, first light-emitting devices (200) in each column are arranged in a second direction (Y), first light-emitting devices (200) of two adjacent columns are misaligned, and the first direction intersects with the second direction (Y); and
a plurality of first pixel driving circuits (300) arranged in an array in the second display sub-region (101b); wherein
the display panel further comprises a plurality of connecting lines (500), wherein the connecting lines (500) are configured to connect the first light-emitting devices (200) to the first pixel driving circuits (300), and at least one of the connecting lines (500) passes through an area between two adjacent first light emitting devices (200) in one column of first light emitting devices (200), and is connected to a first light emitting device (200) in another column of first light emitting devices (200);
wherein the substrate (100) further comprises a second display region (102) on a periphery of the first display region (101); and the display panel further comprises:
a plurality of second light-emitting devices arranged in an array in the second display region, and a plurality of second pixel driving circuits electrically connected with the second light-emitting devices,
wherein an arrangement density of the plurality of second light-emitting devices is higher than an arrangement density of the plurality of first light-emitting devices (200); **characterised in that**
the display panel further comprises a plurality of first signal lines (400) outside the first display sub-region (101a), wherein the first signal lines (400) are configured to connect the connecting lines (500) to the first pixel driving circuits (300), and each of the first signal lines (400) comprises a first connecting portion (401) and a second connecting portion (402), which are connected, wherein the first connecting portion (401) is in the second display sub-region (101b) and electrically connected with each first pixel driving circuit (300) in a column of first pixel driving circuits (300), and the second connecting portion (402) is in the second display region and electrically connected with each second pixel driving circuit in a column of second pixel driving circuits.

2. The display panel according to claim 1, wherein an extending direction of the first signal lines (400) is parallel to a column direction of the first pixel driving circuits (300).

3. The display panel according to claim 1 or 2, further comprising: a plurality of third signal lines (1000) on the substrate, wherein all of the third signal lines (1000) are in the second display region (102), and each of the third signal lines (1000) is electrically connected with each second pixel driving circuit in a column of second pixel driving circuits.

4. The display panel according to any one of claim 1 to 3, further comprising: a plurality of connecting lines (500) on the substrate, wherein one end of each of the connecting lines (500) is electrically connected with one of the first light-emitting devices (200), and the other end of each of the connecting lines (500) is electrically connected with one of the first pixel driving circuits (300).

5. The display panel according to claim 4, wherein a portion, in the first display sub-region (101a), of each of the connecting lines (500) is made of a transparent conductive material.

6. The display panel according to any one of claim 1 to 5, further comprising:
a plurality of third light-emitting devices arranged in an array in the second display sub-region (101b), and a plurality of third pixel driving circuits configured to drive the third light-emitting devices; wherein
in the first direction, at least one of the first pixel drive circuits (300) is between two of the third pixel drive circuits, and at least one of the third pixel drive circuits is between two of the first pixel drive circuits (300).

7. The display panel according to claim 6, wherein an arrangement density of the plurality of third light-emitting devices is equal to the arrangement density of the plurality of first light-emitting devices (200).

8. A display device, comprising a photosensitive sensor (001), and the display panel according to any one of claim 1 to 7, wherein an orthographic projection of a light-receiving surface of the photosensitive sensor (001) on the substrate (100) is in the first display sub-region (101a).

## Patentansprüche

1. Anzeigetafel, umfassend:
ein Substrat (100), das einen ersten Anzeigebereich (101) umfasst, wobei der erste Anzeigebereich (101) einen ersten Anzeigeunterbereich (101a) und einen zweiten Anzeigeunterbereich (101b) umfasst;
eine Vielzahl von ersten Leuchtvorrichtungen (200), die in einer Anordnung in dem ersten Anzeigeunterbereich (101a) angeordnet sind, wobei Spalten von ersten lichtemittierenden Vorrichtungen (200) in einer ersten Richtung angeordnet sind, erste lichtemittierende Vorrichtungen (200) in jeder Spalte in einer zweiten Richtung (Y) angeordnet sind, erste lichtemittierende Vorrichtungen (200) zweier benachbarter Spalten versetzt sind und die erste Richtung die zweite Richtung (Y) schneidet; und
eine Vielzahl von ersten Pixelansteuerschaltungen (300), die in einer Anordnung in dem zweiten Anzeigeunterbereich (101b) angeordnet sind; wobei
die Anzeigetafel ferner eine Vielzahl von Verbindungsleitungen (500) umfasst, wobei die Verbindungsleitungen (500) so konfiguriert sind, dass sie die ersten lichtemittierenden Vorrichtungen (200) mit den ersten Pixelansteuerschaltungen (300) verbinden, und mindestens eine der Verbindungsleitungen (500) durch einen Bereich zwischen zwei benachbarten ersten lichtemittierenden Vorrichtungen (200) in einer Spalte von ersten lichtemittierenden Vorrichtungen (200) verläuft, und mit einer ersten lichtemittierenden Vorrichtung (200) in einer anderen Spalte von ersten lichtemittierenden Vorrichtungen (200) verbunden ist;
wobei das Substrat (100) ferner einen zweiten Anzeigebereich (102) an einer Peripherie des ersten Anzeigebereichs (101) umfasst; und die Anzeigetafel ferner umfasst:
eine Vielzahl von zweiten lichtemittierenden Vorrichtungen, die in einer Anordnung in dem zweiten Anzeigebereich angeordnet sind, und eine Vielzahl von zweiten Pixelansteuerschaltungen, die elektrisch mit den zweiten lichtemittierenden Vorrichtungen verbunden sind,
wobei eine Anordnungsdichte der Vielzahl von zweiten lichtemittierenden Vorrichtungen höher ist als eine Anordnungsdichte der Vielzahl von ersten lichtemittierenden Vorrichtungen (200); **dadurch gekennzeichnet, dass** die Anzeigetafel ferner umfasst
eine Vielzahl von ersten Signalleitungen (400) außerhalb des ersten Anzeigeunterbereichs (101a), wobei die ersten Signalleitungen (400) so konfiguriert sind, dass sie die Verbindungsleitungen (500) mit den ersten Pixelansteuerschaltungen (300) verbinden, und jede der ersten Signalleitungen (400) einen ersten Verbindungsabschnitt (401) und einen zweiten Verbindungsabschnitt (402) umfasst, die verbunden sind, wobei der erste Verbindungsabschnitt (401) in dem zweiten Anzeigeunterbereich (101b) ist und elektrisch mit jeder ersten Pixelansteuerschaltung (300) in einer Spalte von ersten Pixelansteuerschaltungen (300) verbunden ist, und der zweite Verbindungsabschnitt (402) in dem zweiten Anzeigebereich ist und elektrisch mit jeder zweiten Pixelansteuerschaltung in einer Spalte von zweiten Pixelansteuerschaltungen verbunden ist.

2. Anzeigetafel nach Anspruch 1, wobei eine Erstreckungsrichtung der ersten Signalleitungen (400) parallel zu einer Spaltenrichtung der ersten Pixelansteuerschaltungen (300) ist.

3. Anzeigetafel nach Anspruch 1 oder 2, die ferner umfasst: eine Vielzahl von dritten Signalleitungen (1000) auf dem Substrat, wobei alle dritten Signalleitungen (1000) in dem zweiten Anzeigebereich (102) liegen und jede der dritten Signalleitungen (1000) mit jeder zweiten Pixelansteuerschaltung in einer Spalte von zweiten Pixelansteuerschaltungen elektrisch verbunden ist.

4. Anzeigetafel nach einem der Ansprüche 1 bis 3, die ferner umfasst: eine Vielzahl von Verbindungsleitungen (500) auf dem Substrat, wobei ein Ende jeder der Verbindungsleitungen (500) elektrisch mit einer der ersten lichtemittierenden Vorrichtungen (200) verbunden ist und das andere Ende jeder der Verbindungsleitungen (500) elektrisch mit einer der ersten Pixelansteuerschaltungen (300) verbunden ist.

5. Anzeigetafel nach Anspruch 4, wobei ein Teil in dem ersten Anzeigeunterbereich (101a) jeder der Verbindungsleitungen (500) aus einem transparenten leitfähigen Material besteht.

6. Anzeigetafel nach einem der Ansprüche 1 bis 5, ferner umfassend:
eine Vielzahl von dritten lichtemittierenden Vorrichtungen, die in einer Anordnung in dem zweiten Anzeigeunterbereich (101b) angeordnet sind, und eine Vielzahl von dritten Pixelansteuerschaltungen, die zum Ansteuern der dritten lichtemittierenden Vorrichtungen konfiguriert sind; wobei
in der ersten Richtung mindestens eine der ersten Pixelansteuerschaltungen (300) zwischen zwei der dritten Pixelansteuerschaltungen liegt und mindestens eine der dritten Pixelansteuerschaltungen zwischen zwei der ersten Pixelansteuerschaltungen (300) liegt.

7. Anzeigetafel nach Anspruch 6, wobei eine Anordnungsdichte der Vielzahl von dritten lichtemittierenden Vorrichtungen gleich der Anordnungsdichte der Vielzahl von ersten lichtemittierenden Vorrichtungen (200) ist.

8. Anzeigevorrichtung, umfassend einen lichtempfindlichen Sensor (001) und die Anzeigetafel gemäß einem der Ansprüche 1 bis 7, wobei eine orthogonale Projektion einer lichtempfangenden Oberfläche des lichtempfindlichen Sensors (001) auf dem Substrat (100) in dem ersten Anzeigeteilbereich (101a) liegt.

## Revendications

1. Panneau d'affichage, comprenant :
un substrat (100) comprenant une première région d'affichage (101), dans lequel la première région d'affichage (101) comprend une première sous-région d'affichage (101a) et une seconde sous-région d'affichage (101b) ;
une pluralité de premiers dispositifs électroluminescents (200) agencés en un réseau dans la première sous-région d'affichage (101a), dans lequel des colonnes de premiers dispositifs électroluminescents (200) sont agencées dans une première direction, les premiers dispositifs électroluminescents (200) de chaque colonne sont agencés dans une seconde direction (Y), les premiers dispositifs électroluminescents (200) de deux colonnes adjacentes sont décalés, et la première direction croise la seconde direction (Y) ; et
une pluralité de premiers circuits d'attaque de pixels (300) agencés en un réseau dans la seconde sous-région d'affichage (101b) ; dans lequel
le panneau d'affichage comprend également une pluralité de lignes de connexion (500), dans lequel les lignes de connexion (500) sont configurées pour connecter les premiers dispositifs électroluminescents (200) aux premiers circuits d'attaque de pixels (300), et au moins l'une des lignes de connexion (500) traverse une zone entre deux premiers dispositifs électroluminescents adjacents (200) dans une colonne de premiers dispositifs électroluminescents (200), et est connectée à un premier dispositif électroluminescent (200) dans une autre colonne de premiers dispositifs électroluminescents (200) ;
dans lequel le substrat (100) comprend également une seconde région d'affichage (102) sur une périphérie de la première région d'affichage (101) ; et le panneau d'affichage comprend également :
une pluralité de deuxièmes dispositifs électroluminescents agencés en un réseau dans la seconde région d'affichage, et une pluralité de deuxièmes circuits d'attaque de pixels connectés électriquement aux deuxièmes dispositifs électroluminescents,
dans lequel une densité d'agencement de la pluralité de deuxièmes dispositifs électroluminescents est supérieure à une densité d'agencement de la pluralité de premiers dispositifs électroluminescents (200) ; **caractérisé en ce que** le panneau d'affichage comprend également
une pluralité de premières lignes de signal (400) à l'extérieur de la première sous-région d'affichage (101a), dans lequel les premières lignes de signal (400) sont configurées pour connecter les lignes de connexion (500) aux premiers circuits d'attaque de pixels (300), et chacune des premières lignes de signal (400) comprend une première partie de connexion (401) et une seconde partie de connexion (402), qui sont connectées, dans lequel la première partie de connexion (401) est dans la seconde sous-région d'affichage (101b) et est connectée électriquement à chaque premier circuit d'attaque de pixels (300) dans une colonne de premiers circuits d'attaque de pixels (300), et la seconde partie de connexion (402) est dans la seconde région d'affichage et est connectée électriquement à chaque deuxième circuit d'attaque de pixels dans une colonne de deuxièmes circuits d'attaque de pixels.

2. Panneau d'affichage selon la revendication 1, dans lequel une direction d'extension des premières lignes de signal (400) est parallèle à une direction de colonne des premiers circuits d'attaque de pixels (300).

3. Panneau d'affichage selon la revendication 1 ou 2, comprenant également : une pluralité de troisièmes lignes de signal (1000) sur le substrat, dans lequel l'ensemble des troisièmes lignes de signal (1000) se trouvent dans la seconde région d'affichage (102), et chacune des troisièmes lignes de signal (1000) est connectée électriquement à chaque deuxième circuit d'attaque de pixels dans une colonne de deuxièmes circuits d'attaque de pixels.

4. Panneau d'affichage selon l'une quelconque revendication 1 à 3, comprenant également : une pluralité de lignes de connexion (500) sur le substrat, dans lequel une extrémité de chacune des lignes de connexion (500) est connectée électriquement à l'un des premiers dispositifs électroluminescents (200), et l'autre extrémité de chacune des lignes de connexion (500) est connectée électriquement à l'un des premiers circuits d'attaque de pixels (300) .

5. Panneau d'affichage selon la revendication 4, dans lequel une partie, dans la première sous-région d'affichage (101a), de chacune des lignes de connexion (500) est constituée d'un matériau conducteur transparent.

6. Panneau d'affichage selon l'une quelconque revendication 1 à 5, comprenant également :
une pluralité de troisièmes dispositifs électroluminescents agencés en un réseau dans la seconde sous-région d'affichage (101b), et une pluralité de troisièmes circuits d'attaque de pixels configurés pour commander les troisièmes dispositifs électroluminescents ; dans lequel
dans la première direction, au moins l'un des premiers circuits d'attaque de pixels (300) se trouve entre deux des troisièmes circuits d'attaque de pixels, et au moins l'un des troisièmes circuits d'attaque de pixels se trouve entre deux des premiers circuits d'attaque de pixels (300).

7. Panneau d'affichage selon la revendication 6, dans lequel une densité d'agencement de la pluralité de troisièmes dispositifs électroluminescents est égale à la densité d'agencement de la pluralité de premiers dispositifs électroluminescents (200).

8. Dispositif d'affichage, comprenant un capteur photosensible (001), et le panneau d'affichage selon l'une quelconque revendication 1 à 7, dans lequel une projection orthogonale d'une surface de réception de lumière du capteur photosensible (001) sur le substrat (100) se trouve dans la première sous-région d'affichage (101a).
